# EUROPEAN PATENT APPLICATION

(11) **EP 1 134 919 A2**
(43) Date of publication of application: **19.09.2001**
(21) Application number: 01105787.4
(22) Date of filing: 08.03.2001
(51) Int. Cl.: H04H 1/00, H03J 1/00, H03J 7/00

(54) **Receiver for receiving broadcast signals comprising a frequency scanning means**

(30) Priority: 14.03.2000 JP 2000069707
(71) Applicant: CLARION Co., Ltd., Tokyo (JP)
(72) Inventor: Yoshioka, Yasuhiro, Tokyo (JP); Yamakawa, Hiroshi, Tokyo (JP); Tanaka, Tomonori, Tokyo (JP); Noguchi, Takenori, Tokyo (JP)
(74) Representative: Eisenführ, Speiser & Partner

(57) **Abstract**

A broadcast receiver for receiving broadcast programs transmitted at one frequency performs a scanning operation in which the plurality of broadcast programs are automatically switched and output one by one and information about a broadcast program being received is displayed. The manner in which the information is displayed is changed depending upon whether the scanning operation is now being performed so as to avoid a problem in displaying the information.

## Description

### BACKGROUND OF THE INVENTION

### 1. Field of the Invention

The present invention relates to a broadcast receiver for receiving a broadcast program selected from a plurality of broadcast programs transmitted at a single frequency.

### 2. Description of the Related Art

Tasks to establish a standard for a DAB (digital audio broadcasting) for broadcasting digital audio data are now being made. The DAB is capable of providing a high-quality digital audio program or data service to a mobile receiver.

In the DAB, a plurality of broadcast programs can be transmitted at a single frequency (hereinafter referred to as an ensemble) in a multiplexed manner. Minimum units configuring DAB programs are called service components. Each service component includes audio data which is a main part of a program and also includes character information called a service component label indicating the name of the program. One or more service components 203 may be grouped. A data structure in which information about a group is described is called a service. Each service has character information called a service label indicating a group name.

When a receiver receives a service component, the service label and the service component label associated with the service component are displayed on a monitor thereby presenting information about the broadcast program to a user.

In the case where the DAB receiver is of a type which is installed on a car, the DAB receiver cannot include a large-sized monitor, and thus it is impossible to display both service label and service component label at the same time. In such a type of DAB receiver, when a service component is received, an associated service label is first displayed, and then, after a predetermined period of time has elapsed, an associated service component label is displayed.

A service scanning technique is known in the art to present information associated with service components 203 to a user. In this technique, service components 203 contained in one frequency are sequentially received and output at predetermined intervals of time.

However, in the conventional DAB receiver of the type installed on a car, when a service scanning operation is being performed, because both a service label and a service component are displayed within a limited period of time, it is not allowed to display the service component label for a long enough period after the service label was displayed. Thus, after the service component label was displayed for a very short period of time, the displayed information is switched to information associated with a next service component. This causes a problem such as flicker in displaying information.

### SUMMARY OF THE INVENTION

It is an object of the present invention to provide a broadcast receiver which does not have such a problem in displaying information during a scanning operation.

According to an aspect of the present invention, to achieve the above object, there is provided a broadcast receiver comprising: scanning means for performing a scanning operation such that a plurality of broadcast programs are automatically switched and output from one broadcast program to another; and display controlling means for changing a mode in which information is displayed, depending upon whether the scanning operation is being performed, thereby preventing the above-described problem from occurring.

According to another aspect of the present invention, there is provided a broadcast receiver comprising: receiving means for selectively receiving one of a plurality of broadcast programs; operation controlling means for switching the broadcast program received by the receiving means; and scanning means for performing a scanning operation such that the broadcast program received by the receiving means is automatically switched from one broadcast program to another, wherein the broadcast receiver further comprises display controlling means for changing a mode in which the information is displayed, depending upon whether the broadcast program received by the receiving means is selected by the operation controlling means or the scanning means. Because the broadcast program is automatically switched by the scanning means one by one when and only when the scanning operation is being performed, it is possible to change the mode in which the information is displayed depending upon whether the selection of the program is performed by the operation controlling means or the scanning means thereby preventing the above problem from occurring.

### BRIEF DESCRIPTION OF THE DRAWING

Fig. 1 is a block diagram illustrating a broadcast receiver according to the present invention;
Fig. 2 is a schematic diagram illustrating a data structure of a DAB ensemble;
Fig. 3 is a flow chart illustrating a service scanning operation performed by a broadcast receiver, according to a first embodiment of the present invention;
Fig. 4 is a flow chart illustrating a "next service setting" subroutine executed during the service scanning operation performed by the broadcast receiver, according to the first embodiment of the present invention;
Fig. 5 is a flow chart illustrating a subroutine according to a second embodiment of the present invention;
Fig. 6 is a flow chart illustrating a "setting and displaying of next service" subroutine according to the second embodiment of the present invention; and
Fig. 7 is a flow chart illustrating a "setting and displaying of next service" subroutine according to a third embodiment of the present invention.

### DESCRIPTION OF THE PREFERRED EMBODIMENTS

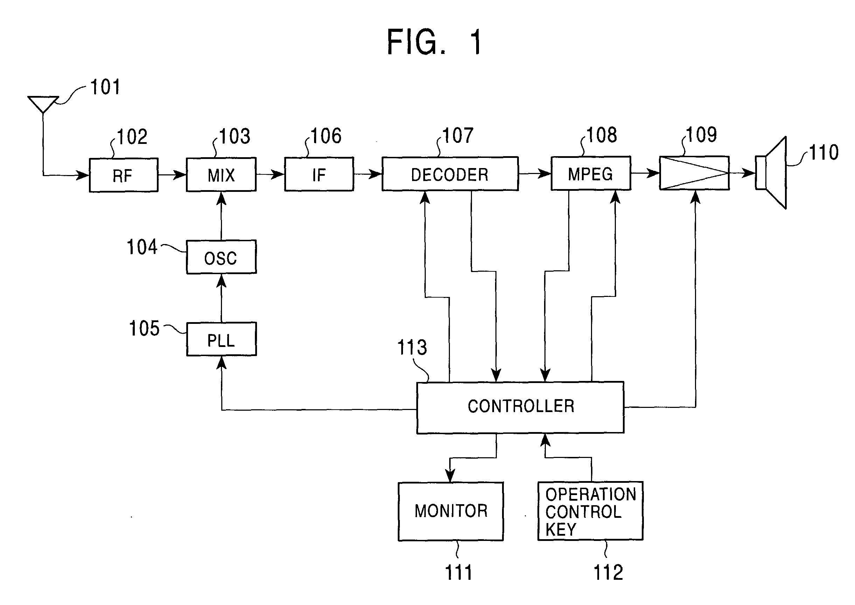

Fig. 1 illustrates a configuration of a DAB receiver according to a first embodiment of the present invention. A DAB signal is first applied to an RF amplifier 102 via an antenna 101 and is amplified to a predetermined level. The amplified DAB signal is then applied to a mixer 103.

The other input of the mixer 103 is connected to a local oscillator 104. By mixing a desired DAB signal frequency and the frequency of the local oscillator 104, the mixer 103 converts the DAB signal frequency into an IF signal. The resultant IF signal is output to an intermediate frequency amplifier 106. In the above operation, in order that a desired DAB signal be converted into an IF signal, a controller 113 adjusts the frequency of the local oscillator 104 by properly setting the division ratio associated with a PLL 105. The intermediate frequency amplifier 106 removes an unnecessary signal component and amplifies the IF signal to a predetermined signal level using AGC or the like. The amplified signal is applied to a DAB signal decoder 107. The controller 113 selects data corresponding to a broadcast program specified by a user by operating an operation control key 112. The selected data is applied to an MPEG audio decoder 108. A signal output from the MPEG audio decoder 108 is applied to an audio amplifier 109. A signal output from the audio signal amplifier is applied to a speaker 110 and thus a DAB audio service is presented to a user.

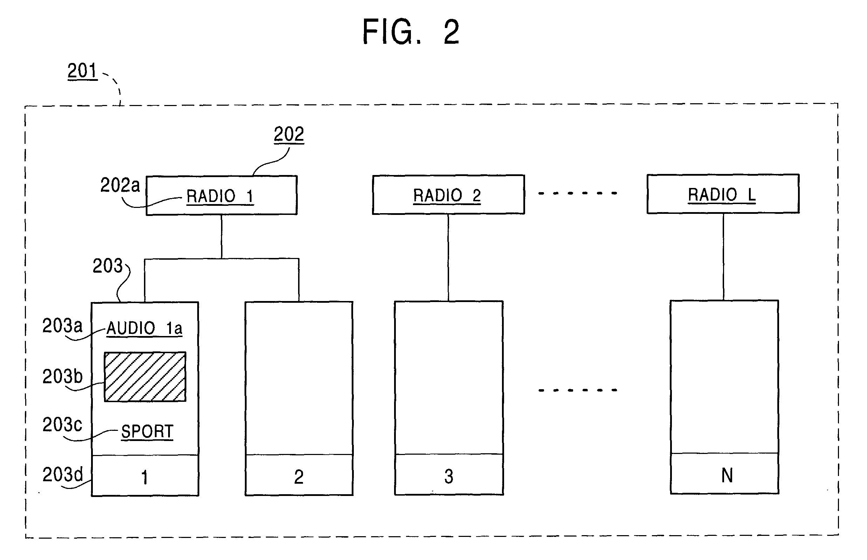

As shown in Fig. 2, a DAB ensemble 201 includes N service components 203. Each service component 203 includes data such as a service component label 203a representing the name of that service component 203, MEPG audio data 203b, a program type 203c representing the type of a broadcast program, and a subchannel Id 203d representing the serial number of that service component 203 wherein the serial numbers are serially assigned to the respective service components contained in each ensemble.

One or more service components 203 are grouped, and a service label 202a indicating the group name thereof is described in a service 202.

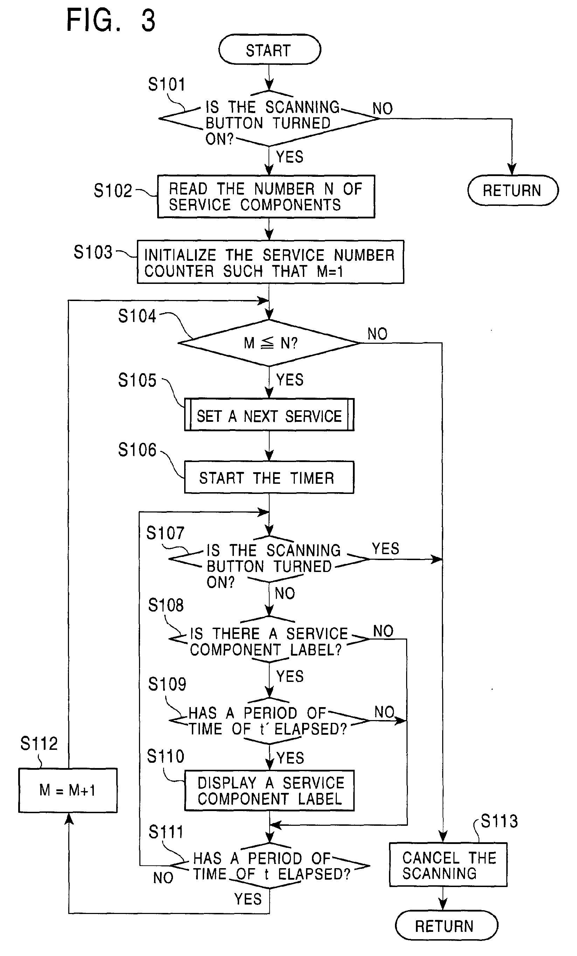

The operation of scanning services according to the first embodiment of the present invention is performed by an interrupt handling routine shown, in the form of a flow chart, in Fig. 3. This interrupt handling routine is performed repeatedly at predetermined intervals of time when the DAB receiver is in operation. In first step S101, it is determined whether a scanning button is pressed. If it is determined in step S101 that the scanning button is pressed, the routine goes to step S102. However, if it is determined in step S101 that the scanning button is not pressed, the operation returns from the interrupt handling routine.

In step S102, the number N of service components contained in an ensemble is read from a DAB service configuration database. Thereafter, in step S103, the value M indicating the subchannel Id of a service component to be scanned for is set to 1. The routine then goes to step S104.

In step S104, M is compared with N. If M > N (that is, if the decision in step S104 is no), it can be concluded that the scanning has been completed for all service components, and thus the operation exits from the scanning mode in step S113 and the operation returns from the interrupt handling routine. On the other hand, if it is determined in step S104 that M ≤ N (that is, if the decision in step S104 is yes), it is determined that the scanning has not been completed for all service components, and the routine goes to step S105 in which a "next service setting" subroutine is executed as will be described in detail later. Thereafter the routine goes to step S106.

A timer is started in step S106, and the routine goes to step S107. In step S107, it is determined whether the scanning button is pressed. If it is determined that the scanning button is pressed (that is, if the decision in step S107 is yes), it is determined that canceling of the service scanning is requested. In response, the operation exits from the scanning mode in step S113, and the operation returns from the interrupt handling routine.

In the case where it is determined in step S107 that the scanning button is not pressed (that is, if the decision in step S107 is no), the routine goes to step S108. In step S108, it is determined whether the service component 203 includes a service component label 203a. If a service component label 203a is not found, (that is, if the decision in step S108 is no), the routine goes to step S111. However, if a service component label 203a is found (that is, if the decision in step S108 is yes), the routine goes to step S109.

In step S109, it is determined whether a predetermined period of time t' has elapsed since the timer was started in step S106. If the predetermined period of time t' has elapsed (that is, if the decision in step S109 is yes), then the service component label 203a is displayed in step S110 and the routine goes to step S111. However, if the predetermined period of time t' has not elapsed (that is, if the decision in step S109 is no), then the routine goes to step S111 without displaying the service component label.

In step S111, it is determined whether a predetermined period of time t has elapsed since the timer was started in step S106. If the predetermined period of time t has elapsed (that is, if the decision in step S111 is yes), it is determined that the scanning for the service component 203 has been completed, and thus the routine goes to step S112 in which M is incremented by 1. Thereafter, the routine returns to step S104. In the case where the predetermined period of time t has not elapsed (that is, if the decision in step S111 is no), the routine returns to step S107.

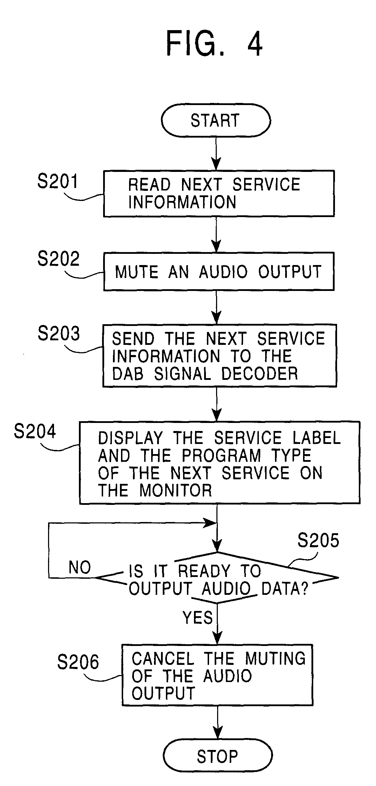

Now, the "next service setting" subroutine in step S105 is described below with reference to Fig. 4. In step 201, the subroutine reads next service information needed for the DAB signal decoder 107 to read a service component 203 having a subchannel Id 203d equal to the variable M described above with reference to Fig. 3. In next step S202 an audio output is muted, and the subroutine goes to step S203.

In step S203, the next service information is sent to the DAB signal decoder 107, and the subroutine goes to step S204. In step S204, the subroutine displays, on the monitor 111, the program type 203c of the service component 203 whose subchannel Id 203d is equal to the variable M described above with reference to Fig. 3 and also displays a service label 202a indicating a group to which the service component 203 belongs.

Thereafter, the subroutine waits in step S205 until the MPEG decoder 108 becomes ready to output audio data. When the MPEG decoder 108 becomes ready to output audio data (that is, if the decision in step S205 is yes), the subroutine goes to step S206 in which the muting of the audio output is cancelled so that audio data of the service component 203 of the next service (which is currently selected and the information of which is displayed on the monitor 111) is output from the speaker 110.

Thus, the service scanning operation is performed by executing the above-described interrupt handling routine in which service components are switched from one to another at the constant intervals of time t and output to the speaker 110, and the service label 202a or the service component label 203a corresponding to the audio data output from the speaker 110 is displayed on the monitor 111.

In this first embodiment of the present invention, t' and t are selected such that t' > t. Therefore, the elapsed time does not reach t' and the routine does not go to step S110 during a period in which steps S107 to S111 in Fig. 3 are being performed repeatedly (as long as the decision in step S111 is no). Therefore, the service component label 203a is not displayed during the service scanning operation. That is, during the service scanning operation, the displaying operation is performed such that the service label 202a of the service component 203 whose subchannel Id 203d is equal to 1 is displayed for t sec → the service label 202a of the service component 203 whose subchannel Id 203d is equal to 2 is displayed for t sec → ,..., → the service label 202a of the service component 203 whose subchannel Id 203d is equal to N is displayed for t sec. Thus, the operation according to the first embodiment of the present invention does not have the problem that the service component label 203a is displayed in a short period during the scanning operation.

Because the operation shown in Fig. 3 is performed according to the same processing flow as that employed in the conventional scanning operation only except that t and t' are selected such that t' > t instead of the conventional manner in which t and t' are selected such that t' < t, the problem is avoided without changing the flow employed in the conventional process. Note that the purpose of the present invention can be achieved if steps S108 to S110 are removed.

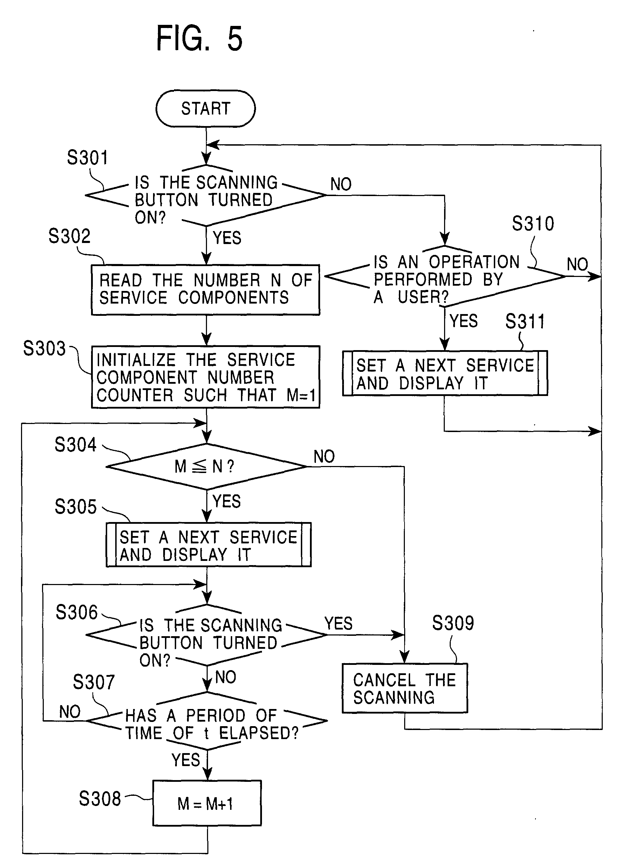

Fig. 5 illustrates a processing flow according to a second embodiment of the present invention. The processing flow shown in Fig. 5 is an interrupt handling routine which is periodically executed to detect an operation performed by a user to specify a broadcast program. This interrupt handling routine according to the second embodiment of the present invention is performed in the same broadcast receiver as the broadcast receiver according to the first embodiment described earlier with reference to the block diagram shown in Fig. 1, and thus the broadcast receiver is not described in further detail herein.

In step S301, it is determined whether the scanning button which is one of the operation control keys 112 is pressed. If the scanning button is not pressed (that is, if the decision in step S301 is no), the routine goes to step S310. In step S310, it is determined whether a service component 203 is specified by a user. If it is determined in step S310 that no service component 203 is specified by the user (that is, if the decision in step S310 is no), the routine returns to S301.

In the case where it is determined in step S301 that the scanning button is pressed (that is, if the decision in step S301 is yes), the routine goes to step S302. In step S302, the number N of service components 203 contained in an ensemble is read from the DAB service configuration database. Thereafter, in step S303, the value M indicating the subchannel Id 203d of a service component 203 to be scanned for is set to 1. The routine then goes to step S304.

In step S304, M is compared with N. If M > N (that is, if the decision in step S304 is no), it can be concluded that the scanning has been completed for all service components, and thus the operation exits from the scanning mode in step S309 and the routine returns to step S301. On the other hand, if it is determined in step S304 that M ≤ N (that is, if the decision in step S304 is yes), it is determined that the scanning has not been completed for all service components, and the routine goes to step S305 in which a "setting and displaying of next service" subroutine is executed. Thereafter, the routine goes to step S306.

In step S306, it is determined whether the scanning button is pressed. If the scanning button is pressed, that is, if the service scanning operation is cancelled (if the decision in step 306 is yes), the operation exits from the scanning mode in step S309 and the routine returns to step S301. However, if it is determined in step S306 that the scanning button is not pressed (if the decision in step S306 is no), the routine goes to step S307.

In step S307, it is determined whether the elapsed time counted by a timer which was started in step S405 (described later) in the "setting and displaying of next service" subroutine in step S305 has reached a predetermined time t. If the elapsed time counted by the timer has reached the predetermined time t (that is, if the decision in step S307 is yes), the routine goes to step S308 in which the counter value M indicating the service component number is incremented by 1. Thereafter, the routine returns to step S304 to scan for a next service component. In the case where it is determined in step S307 that the elapsed time counted by the timer has not reached the predetermined time t (that is, if the decision in step S307 is no), the routine returns to step S306.

In the case where it is determined in step S310 that a service component 203 is specified by the user (that is, if the decision in step S310 is yes), the routine goes to step S311 to execute the "setting and displaying of next service" subroutine. Thereafter, the routine returns to step S301.

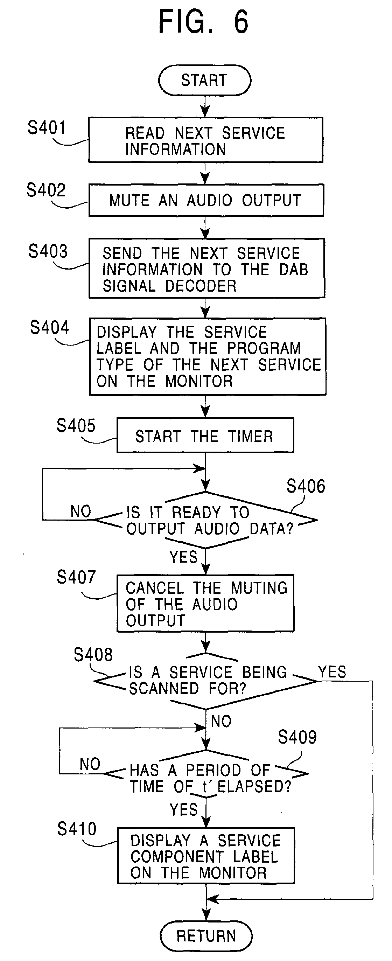

Fig. 6 illustrates the "setting and displaying of next service" subroutine executed in the routine shown in Fig. 5. In step 401, the subroutine reads next service information needed for the DAB signal decoder 107 to read a next service component 203. In next step S402 an audio output is muted, and the subroutine goes to step S403.

In step S403, the next service information is sent to the DAB signal decoder 107. Thereafter, in next step S404, the subroutine displays, on the monitor 111, the program type 203c of the next service component 203 and also displays a service label 202a indicating a group to which the service component 203 belongs.

Thereafter, the timer is started in next step S405, and the subroutine returns to step S406. The subroutine waits in step S406 until the MPEG decoder 108 becomes ready to output audio data. When the MPEG decoder 108 becomes ready to output audio data (that is, if the decision in step S406 is yes), the subroutine goes to step S407 in which the muting of the audio output is cancelled so that audio data of a service component 203 of the next service is output from the speaker 110.

In next step S408, it is determined whether the service scanning operation is being performed. If the service scanning operation is being performed, that is, in the case where the present subroutine is executed at step S305 (that is, if the decision in step S408 is yes), the operation returns from the subroutine to step S306 in the main routine without displaying the service component label 203a. In the case where it is determined in step S408 that the scanning operating is not being performed, that is, in the case where the present subroutine is executed at step S311 (that is, the decision in step S408 is no), the subroutine goes to step 409.

In step S409, the subroutine waits until the elapsed time since the timer was started in step S405 reaches a predetermined time t'. If the elapsed time since the timer started in step S405 has reached the predetermined time t' (if the decision in step S409 is yes), the service component label 203a is displayed on the monitor 111 and the operation returns from the subroutine to step S301.

In the case where a next service is automatically selected during the scanning operation, only the service label 202a is displayed. That is, during the scanning operation, the displaying operation is performed such that the service label 202a of the service component 203 whose subchannel Id 203d is equal to 1 is displayed for t sec → the service label 202a of the service component 203 whose subchannel Id 203d is equal to 2 is displayed for t sec → ,..., → the service label 202a of the service component 203 whose subchannel Id 203d is equal to N is displayed for t sec. Thus, the operation does not have the problem that the service component label 203a is displayed in a short period during the scanning operation.

In the case where a next service was selected by an operation performed by a user, a service label 202a is displayed for t' sec and then a service component label 203a is displayed. In this case, the service component label 203a is displayed on the monitor 111 for a sufficiently long period for the user to visually recognize the service component label 203a. Thus, the user can see the service label 202a and the service component label 203a associated with the broadcast program selected by the user.

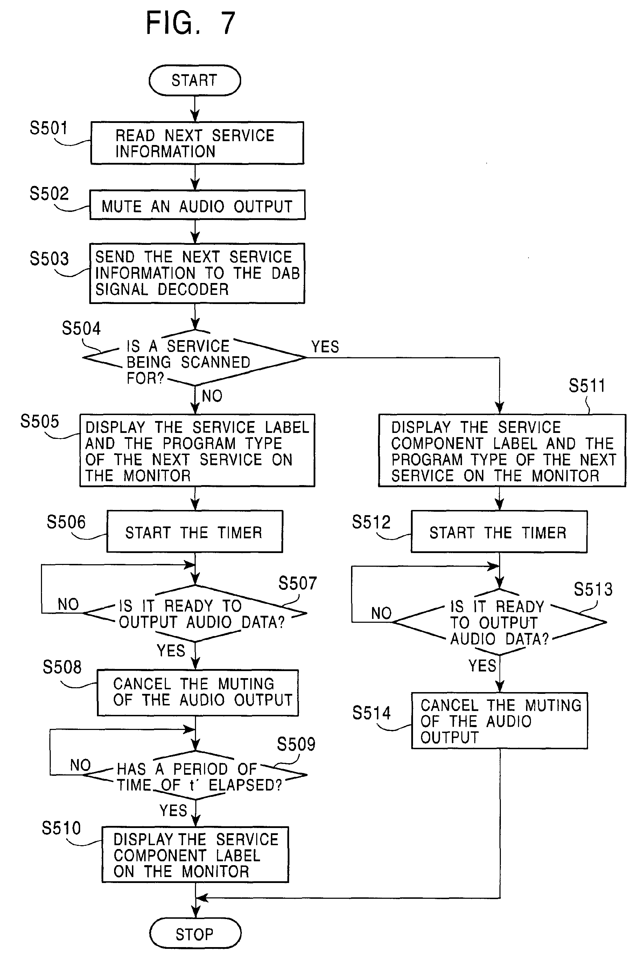

Fig. 7 is a flow chart illustrating the "setting and displaying of next service" subroutine according to a third embodiment of the present invention. This subroutine according to the third embodiment is executed in the same broadcast receiver in the same main routine as those employed in the second embodiment, and thus the broadcast receiver and the main routine are not described in further detail herein.

In step 501, the subroutine reads next service information needed for the DAB signal decoder 107 to read a next service component 203. In next step S502 an audio output is muted, and the subroutine goes to step S503.

In step S503, the next service information is sent to the DAB signal decoder 107. Thereafter, in next step S504, it is determined whether the service scanning operation is being performed. If the service scanning operation is being performed, that is, in the case where the present subroutine is executed at step S305 (that is, if the decision in step S504 is yes), the subroutine goes to step S511 in which the service component label 203a and the program type 203d are displayed on the monitor 111.

Thereafter, the timer is started in next step S512, and the subroutine goes to step S513. The subroutine waits in step S513 until the MPEG decoder 108 becomes ready to output audio data. When the MPEG decoder 108 becomes ready to output audio data (that is, if the decision in step S513 is yes), the subroutine goes to step S514 in which the muting of the audio output is cancelled so that audio data of a service component 203 of the next service is output from the speaker 110. Thereafter, the operation exits from the subroutine.

In the case where it is determined in step S504 that the scanning operation is not being performed (that is, if the decision in step S504 is no), the subroutine goes to step S505. In step S505, the subroutine displays, on the monitor 111, the program type 203c of the next service component 203 and also displays a service label 202a indicating a group to which the service component 203 belongs.

Thereafter, the timer is started in next step S506, and the subroutine returns to step S507. The subroutine waits in step S507 until the MPEG decoder 108 becomes ready to output audio data. When the MPEG decoder 108 becomes ready to output audio data (that is, if the decision in step S507 is yes), the subroutine goes to step S508 in which the muting of the audio output is cancelled so that audio data of a service component 203 of the next service is output from the speaker 110.

The subroutine the goes to step S509. In step S509, the subroutine waits until the elapsed time since the timer was started in step S506 reaches a predetermined time t'. If the elapsed time since the timer started in step S506 has reached the predetermined time t' (if the decision in step S509 is yes), the service component label 203a is displayed on the monitor 111 and the operation returns from the subroutine.

In the case where a next service is automatically selected during the scanning operation, only the service component label 203a is displayed. That is, during the scanning operation, the displaying operation is performed such that the service component label 203a of the service component 203 whose subchannel Id 203d is equal to 1 is displayed for t sec → the service component label 203a of the service component 203 whose subchannel Id 203d is equal to 2 is displayed for t sec →,...,→ the service component label 203a of the service component 203 whose subchannel Id 203d is equal to N is displayed for t sec. Thus, the operation does not have the problem that the service label 202a is displayed in a short period during the scanning operation.

In the case where a next service was selected by an operation performed by a user, a service label 202a is displayed for t' sec and then a service component label 203a is displayed. In this case, the service component label 203a is displayed on the monitor 111 for a sufficiently long period for the user to visually recognize the service component label 203a. Thus, the user can see the service label 202a and the service component label 203a associated with the broadcast program selected by the user.

## Claims

1. A broadcast receiver for receiving one of a plurality of broadcast programs transmitted at one frequency, said broadcast receiver comprising:
information displaying means (111) for displaying information associated with said broadcast programs;
scanning means (113) for performing a scanning operation such that said plurality of broadcast programs are automatically switched and output from one broadcast program to another; and
display controlling means (113) for changing a mode in which said information is displayed, depending upon whether said scanning operation is being performed.

2. A broadcast receiver according to Claim 1, wherein
said information includes a first label and a second label; and
said information displaying means (111) displays said first label or said second label.

3. A broadcast receiver according to Claim 1, further comprising operation controlling means for outputting a broadcast program in response to an operation performed by a user, wherein
said information includes a first label and a second label; and
said information displaying means (111) displays said first label or said second label.

4. A broadcast receiver for receiving one of a plurality of broadcast programs transmitted at one frequency, said broadcast receiver comprising:
receiving means for selectively receiving one of said plurality of broadcast programs;
operation controlling means for switching the broadcast program received by said receiving means;
scanning means (113) for performing a scanning operation such that the broadcast program received by said receiving means is automatically switched from one broadcast program to another; and
information displaying means (111) for displaying information associated with the selected broadcast program, said broadcast receiving further comprising
display controlling means (113) for changing a mode in which said information is displayed, depending upon whether said broadcast program received by said receiving means is selected by said operation controlling means or said scanning means (113).

5. A broadcast receiver according to Claim 2 or 3, wherein when said scanning operation is not performed, said display controlling means (113) first displays the first label and then displays the second label after a predetermined period of time has elapsed.

6. A broadcast receiver according to one of Claims 2, 3, and 5, wherein said display controlling means (113) displays only the first label when said scanning operation is being performed.

7. A broadcast receiver according to one of Claims 2, 3, and 5, wherein said display controlling means (113) displays only the second label when said scanning operation is being performed.

8. A broadcast receiver according to one of Claims 2, 3, and 5 to 8, wherein one of said first and second labels is a service label of digital audio broadcasting, and the other one is a service component label.

9. A broadcast receiver according to one of Claims 1 to 8, wherein said information displaying means (111) is a display for displaying a character.
